# EUROPEAN PATENT SPECIFICATION

(11) **EP 0 801 496 B1**
(45) Date of publication and mention of the grant of the patent: **16.08.2001**
(21) Application number: 97302473.0
(22) Date of filing: 10.04.1997
(51) Int. Cl.: H04N 5/238

(54) **Color image pickup apparatus**
Farbbildaufnahmegerät
Appareil de prise de vues en couleurs

(30) Priority: 12.04.1996 JP 9159696
(43) Date of publication of application: 15.10.1997
(73) Proprietor: SONY CORPORATION, Tokyo 141 (JP)
(72) Inventor: Tsuchiya, Takashi, Shinagawa-ku, Tokyo 141 (JP)
(74) Representative: Pratt, Richard Wilson

(56) References cited:
- EP-A- 0 552 016
- US-A- 5 049 997
- US-A- 5 353 058
- PATENT ABSTRACTS OF JAPAN vol. 015, no. 375 (E-1114), 20 September 1991 & JP 03 148987 A (MINOLTA CAMERA CO LTD), 25 June 1991

## Description

In general, for obtaining a pick-up output having excellent quality secured therein, an image pickup device is required to pick up an image in proper exposure to light. The image pickup device is arranged to detect a signal level of an image picked by an image pickup unit and automatically control an iris diaphragm of the image pickup unit according to the detected signal level. The conventional image pickup device operates to detect the signal of the overall pick-up image covering the background and automatically control an iris diaphragm based on the detected result. In order to correct the exposure, the conventional image pickup device performs the automatic iris control that operates to change an interior divisional ratio of a peak value to an average luminance level of an overall screen for shifting a target value to a bright or a dark side.

In general, for obtaining a pick-up output having excellent quality secured therein, an image pickup device is required to pick up an image in proper exposure to light. The image pickup device is arranged to detect a signal level of an image picked by an image pickup unit and automatically control an iris diaphragm of the image pickup unit according to the detected signal level. The conventional image pickup device operates to detect the signal of the overall pick-up image covering the background and automatically control an iris diaphragm based on the detected result. In order to correct the exposure, the conventional image pickup device performs the automatic iris control that operates to change an interior divisional ratio of a peak value to an average luminance level of an overall screen for shifting a target value to a bright or a dark side.

A conventional colour image pickup device has been arranged to detect the signal level of an image for the overall screen and automatically control an iris diaphragm based on the detected signal level. The aperture value may be influenced by the signal level of the overall screen, but not the target object. It means that the signal level of the background image may produce an aperture value which is not appropriate to the target object.

For example, the target object may be made shadowed in a backlighted condition, while it may be subject to halation in an excessively lighted condition. The brightness of the background may be an obstacle to proper exposure of the target object. Further, the automatic iris control executed in the conventional image pickup device is arranged to vary a ratio of a peak value to an average luminance level of the overall screen for correcting the aperture value for the target. This control may result in an erroneous aperture value if a highly luminous portion is present in the image. Moreover, a small difference between the peak value and the average luminance level may result in errors. Hence, disadvantageously, it cannot provide a proper aperture value for a specific area of the screen.

US-A- 5,353,058 and US-A-5,049,997 disclose image pick-up devices having automatic iris control. US-A-5,353,058 disclose a control, for a colour camera, which control divides a frame into a plurality of areas and detects the levels of the image signal in the areas.

In consideration of the foregoing conventional disadvantages an embodiment of the invention seeks to provide an image pickup device that enables to control the exposure so that the brightness of the target object is made proper independently of the brightness of the background, for the purpose of producing an image of excellent quality.

According to the present invention, there is provided an image pickup apparatus comprising:
image pickup means for sensing a picture and generating a corresponding image signal;
automatic iris means for controlling an iris of said image pickup means;
first average picture level detection means for detecting a first average picture level of the image signal within a first area defined by a position in said sensed picture; and
second average picture level detection means for detecting a second average picture level of the image signal within a second area in which a picture level is between a first threshold level and a second threshold level;
characterised by
iris control means for controlling said automatic iris means on the basis of said first or second average picture level; and
means for adjusting the first and second threshold levels so that the first average picture level, obtained when the iris control means controls said automatic iris means on the basis of only said first average picture level, becomes a centre level of the adjusted first and second threshold levels.

Preferably, the said first area is positioned in the centre of the frame.

For a better understanding of the present invention, reference will now be made, by way of example, to the accompanying drawings, in which:

Fig.1 is a block diagram showing a schematic arrangement of a color image pickup device according to the present invention.

Fig.2 is a block diagram showing an arrangement of an iris control unit included in the color image pickup device.

Fig.3 is a view exemplarily showing an example of a luminance distribution of an imaging scene for describing the iris control at the luminance gate mode in the color image pickup device.

Fig.4 is a view exemplarily showing an example of a luminance distribution of an imaging scene for describing the iris control at the luminance gate mode in the backlighted condition or excessive lighted condition.

Fig.5 is a view exemplarily showing an imaging scene for describing the iris control at the spot mode executed in the color image pickup device.

Fig.6 is a view exemplarily showing an imaging scene for describing the iris control at the spot mode executed in the color image pickup device.

Fig.7 is a view exemplarily showing an example of a function for defining a weight added to the skin tone mode for describing the iris control at the intelligent mode executed in the color image pickup device.

Fig.8 is a view exemplarily showing an example of a luminance distribution of an imaging scene for describing the iris shift operation at the intelligent mode.

Fig.9 is a view exemplarily showing an example of a luminance distribution of an imaging scene for describing the one push operation at the intelligent mode.

Fig.10 is a flowchart showing a procedure for doing the one-push operation executed in the system controller included in the color image pickup device.

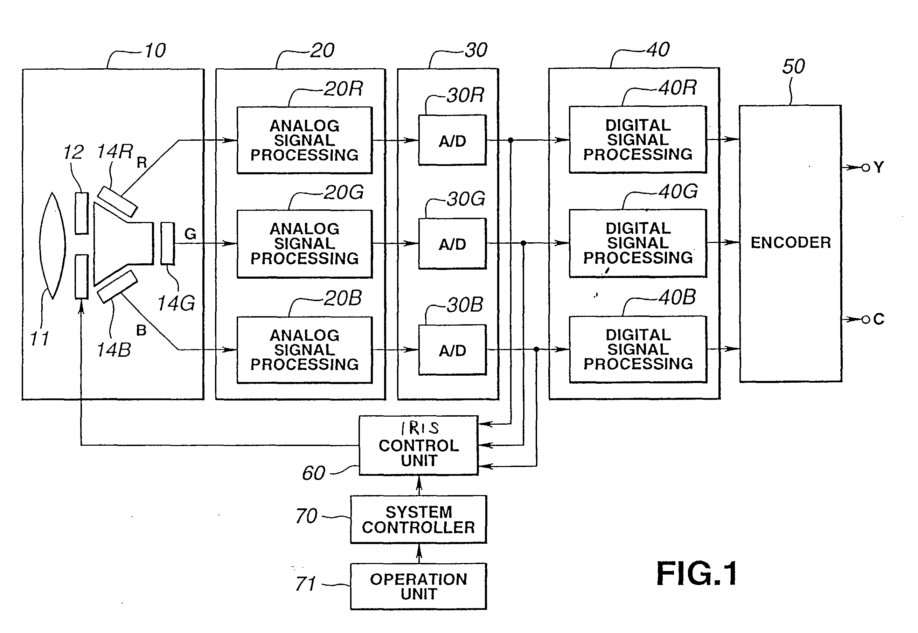

An illustrative color image pickup device according to the present invention is arranged as shown in Fig.1. The color image pickup device as shown in Fig.1 includes an image pickup unit 10, an analog-to-digital (A/D) converting nit 30 for receiving three primary color imaging signals R, G and B obtained from the image pickup unit 10 through an analog signal processing unit 20, a digital signal processing unit 40 and an iris control unit 60 for receiving these color imaging data R, G and B digitized by the A/D converting unit 30, an ancoder 50 for receiving a digital luminance signal Y and two digital color difference signals CR and CB generated by the digital signal processing unit 40, a system controller 70 connected to the iris control unit 60, and an operation unit 80 connected to the system controller 70.

The image pickup unit 10 is a color image pickup unit provided with means for controlling light quantity. For example, imaging light enters into the image pickup unit 10 from an imaging lens 11 through an iris diaphragm 12. In the image pickup unit 10, the imaging light is separated into three primary color light components through the *effect* of a *color* separating prism 13. Then, the three pictures *of each primary color* are picked up by three CCD image sensors 14R, 14G and 14B. The iris diaphragm 12 is acted as means for controlling light quantity.

The color imaging signals R, G and B, obtained by the CCD image sensors 14R, 14G and 14B that operate to pick up the three primary color images of an object image, are supplied to the A/D converting unit 30 through the analog signal processing unit 20.

The analog signal processing unit 20 performs analog signal processing containing various kinds of level controls such as noise removal done by correlated double sampling (CDS), gain control, black balance, white balance and shooting correction with respect to the color imaging signals R, G and B read from the corresponding CCD image sensors contained in the imaging unit 10

Further, the A/D converting unit 30 includes A/D converters 30R, 30G and 30B, which perform the corresponding A/D converting processes at a clock rate equal to the sampling rate of each analog color imaging signal R, G or B and in synchronous to a driving clock. As a result, the color imaging signals R, G and B are digitized. The digital color signals R, G and B converted by the A/D converting unit 3 are supplied to the digital signal processing unit 40 and the iris control unit 60.

The digital signal processing unit 40 performs nonlinear processing such as picture emphasis, pedestal addition, gamma correction and knee characteristic correction with respect to the digital color signals R, G and B supplied from the A/D converting unit 30. Further, a matrix operation is executed to generate a digital luminance signal Y and two digital color difference signals CR and CB from these digital color signals R, G and B. The digital luminance signal Y and the two digital color difference signals CR and CB generated by the digital signal processing unit 40 are supplied to the encoder 50.

The encoder 50 operates to generats a luminance signal Y and a chromatic signal C according to the NTSC or PAL from the digital luminance signal Y and the two digital color difference signals CR and CB generated by the digital signal procassing unit 40.

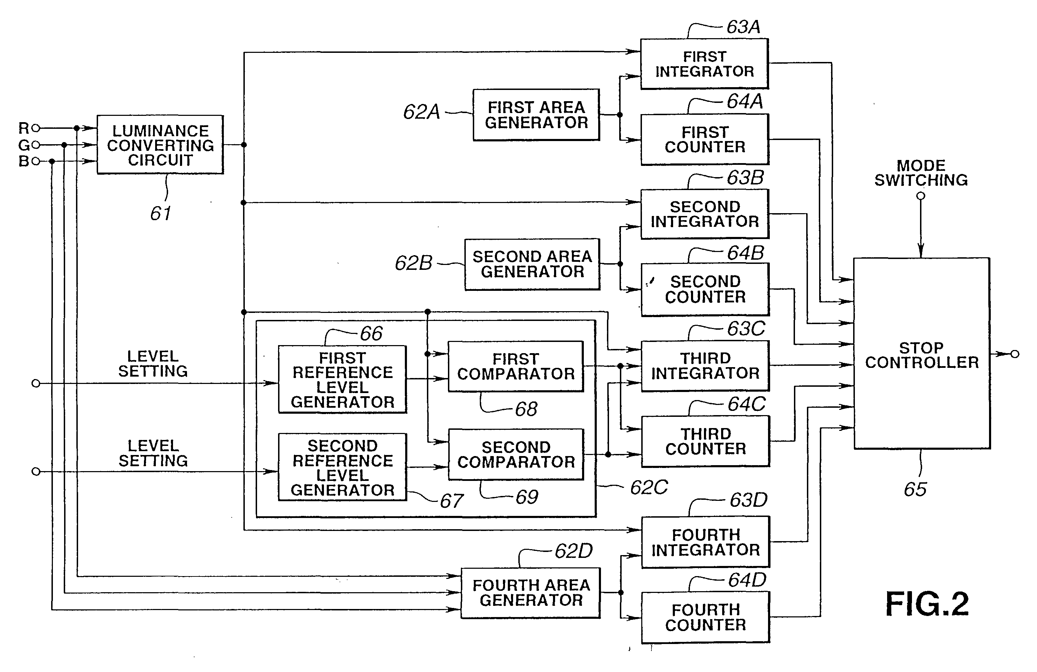

Further, the iris control unit 60 is served as level sensing means for sensing an output level of an image picked up by the imaging unit 10 and control means for controlling means for controlling light quantity of the color image pickup unit. This iris control unit 6 is arranged as shown in Fig.2.

That is, this iris control unit 60 is arranged to have a luminance converting circuit 61, first to fourth area generators 62A to 62D, first to fourth integrators 63A to 63D, first to fourth counters 64A to 64D and an iris controller 65. The digital color signals R, G and B digitized by the A/D converting unit 3 are supplied to the luminance converting circuit 61 and the fourth area generator 62D.

The luminance converting circuit 61 is served as luminance converting means for converting the color imaging signal obtained by the color imaging unit into a luminance signal. The digital color signals R, G and B digitized by the A/D converting unit 3 are converted into a digital luminance signal Y. The digital luminance signal Y obtained by the luminance converting circuit 61 is supplied to the third area generator 62C as well as the first to the fourth integrators 63A to 63D.

The first to the fourth area generators 62A to 62D operate to generate the corresponding gate pulses in the corresponding specific areas contained in the imaged screen. These gate pulses are supplied to the corresponding first to fourth integrators 63A to 63D and first to fourth counters 64A to 64D.

Herein, the first area generator 62A is arranged to supply the gate pulse for the overall imaged screen as its specific area to the first integrator 63A and the first counter 64A.

The second area generator 62B is arranged to supply the gate pulse for a rectangle area SPOT located on the center of the imaged screen as its specific area to the second integrator 63B and the second counter 64B.

Further, the third area generator 62C is arranged to supply the first and the second gate pulses for a specific luminance level area of the imaged screen as its specific area to the third integrator 63C and the third counter 64C. The third area generator 62C is composed of first and second reference level generators 66 and 67 and first and second level comparators 68 and 69. The first level comparator 68 operates to compare a reference upper limit level IRSHI generated by the first reference level generator 66 with a digital luminance signal Y obtained by the luminance converting circuit 61 in magnitude. If the digital luminance signal Y is equal to or lower than the reference upper limit level IRSHI, the comparator 68 operates to output the first luminance gate pulse. The second level comparator 69 operates to compare a reference lower limit level IRSLO generated by the second reference level comparator 67 with the digital luminance signal Y obtained by the luminance converting circuit 61 in magnitude. If the digital luminance signal Y is greater than or equal to the reference lower limit level IRSLO, the comparator 69 operates to output the second luminance gate pulse. Further, the first and the second reference level generators 66 and 67 may have the reference upper limit level IRSHI and the reference lower limit level IRSLO varied under the control of the system controller 70.

Further, the fourth area generator 62D is arranged to supply the gate pulse for a skin tone area of the imaged screen as its specific area to the fourth integrator 63D and the fourth counter 64D, The fourth area generator 62D operates to decode the digital color signals R, G and B supplied from the A/D converting unit 3 for sensing the skin tone area and thereby generating the gate pulse.

The first to the fourth integrators 63A to 63D are arranged to integrate the digital luminance signal Y obtained by the luminance converting circuit 61 within each specific area, based on the gate pulses for the specific areas inside of the imaged screen generated by the first to the fourth area generators 62A to 62D and then to supply each integral value to the iris controller 65. The first counter 64A operates to integrate the digital luminance signal Y with the overall imaged screen as its specific area and supply the integral value to the iris controller 65. The second integrator 63B operates to integrate the digital luminance signal Y with the rectangle area SPOT located on the center of the imaged screen as its specific area and to supply the integral value to the iris controller 65, The third integrator 63C operates to integrate the digital luminance signal Y with a specific luminance level area inside of the imaged screen as its specific area and then to supply the integral value to the iris controller 65. Further, the fourth integrator 63D operates to integrate the digital luminance signal Y with the skin tone area inside of the imaged screen as its specific area and then supply the integral value to the iris controller 65.

The first to the fourth counters 64A to 64D are arranged to count the number of pixels contained in each specific area based on the gate pulse for each specific area inside of the imaged screen generated by the first to the fourth area generators 62A to 62D and then to supply each count value to the iris controller 65. The first integrator 63A operates to count the number of pixels with the overall imaged screen as its specific arsa and supply the count value to the iris controller 65. The second integrator 64B operates to count the number of pixels with the rectangle area SPOT located on the center of the imaged screen as its specific area and to supply the count value to the iris controller 65. The third integrator 64C operates to count the number of pixels with a specific luminance level area inside of the imaged screen as its specific area and then to supply the count value to the iris controller 65, And, the fourth counter 64D operates to count the number of pixels contained in the skin tone area inside of the imaged screen as its specific area and then to supply the count value to the iris controller 65.

Moreover, the operation mode of the iris controller 65 is switched by the system controller 70 in response to the operating input of the operation unit (71). The iris controller 65 is operated to perform the following iris controls at various modes, based on the integral value of the digital luminance signal Y of each specific area obtained by the first to the fourth integrators 63A to 63D and the count value indicating the number of the pixels inside of each specific area obtained by the first to the fourth counters 64A to 64D.

At the full-screen mode, the iris diaphragm 12 of the image pickup unit 10 is controlled to derive an average picture level (APL) of the overall imaged screen from the integral value of the digital luminance signal Y that specifies the overall imaged screen as its specific area, which value is produced by the first integrator 63A, and the number of pixels that specifies the overall imaged screen as its specific area, which number is obtained as a count value of the first counter 64A, and adjust the average picture level to a predetermined level.

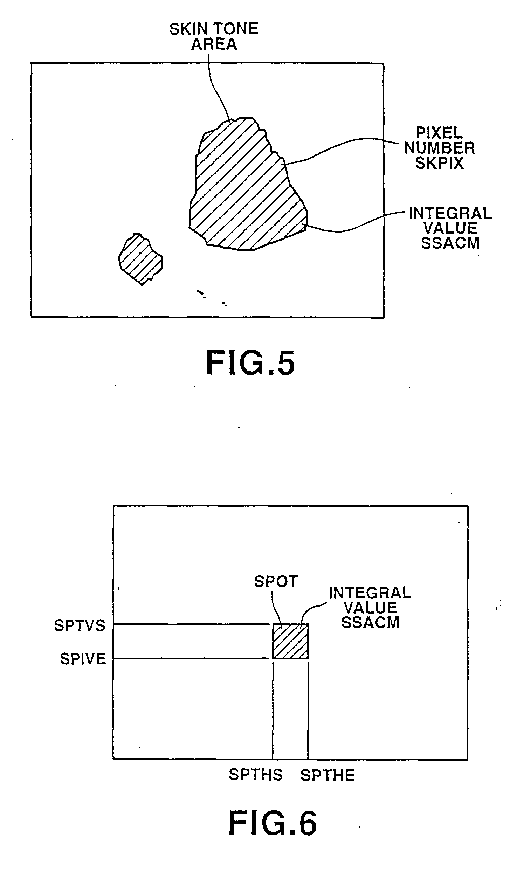

At the spot mode, the iris diaphragm 12 of the image pickup unit 10 is controlled to derive an average picture level PSPT of the rectangle area SPOT from an integral value SSACM of the digital luminance signal Y that specifies the rectangle area APOT located on the center of the imaged screen as its specific area, which value is produced by the second integrator 63B, and the number of pixels of the rectangle area SPOT that is obtained as a count value of the second counter 64B and adjust the average picture level to a predetermined level. At this spot mode, as shown in Fig.6, the gate signal of the rectangle area SPOT is multiplied by the input signal and then is output as a sensing signal. At this spot mode, the average picture level PSPT may be derived from a horizontal start position SPTHS and a horizontal end position SPTHE and a vertical start position SPTVS and a vertical end position SPHTVE by the expression of:$\text{PSPT = SSMAC/k(SPTHE - SPTHS)(SPHTVE - SPTVS)}$ where k is a coefficient provided if the digital luminance signal Y is sampled down.

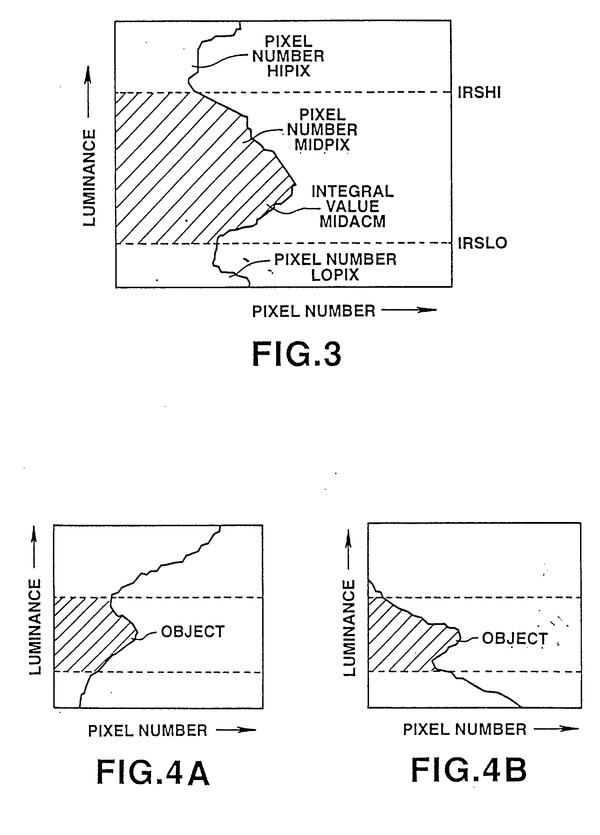

At a luminance gate mode, the iris diaphragm 12 of the image pickup unit 10 is controlled to derive an average picture level PMID of the area of the specific luminance level from an integral value MIDACM of the digital luminance signal Y that specifies the specific luminance level area inside of the imaged screen as its specific area, which value is produced by the third integrator 63C, and the number of pixels MIDPIX of the specific luminance level area that is obtained as a count value of the third counter 64c and adjust the average picture level to a predetermined level. At the luminance gate mode, as shown in Fig.3, the luminance gate signal is multiplied by the input signal and then is output as a sending signal. At this luminance gate mode, the system controller 70 is operated to specify the upper limit IRSHI and the lower limit IRSLO of the luminance and derive the average picture level PMID about a specific area where only the pixels having the luminance level kept within that specific luminance level are detectd by the expression of:$\text{PMID = MIDACM / MIDPIX}$ At this luminance gate mode, as shown in Fig.4A and 4B, the iris value is not influenced by a too much brighter portion or a too much gloomier portion than the specified bright range (that is close to the brightness of the object). Hence, even the backlight, the excessive light, or the invasion of illumination or the sun into the screen does not bring about the shadow or the halation on the target object. If the lighting condition is changed when the shooter goes outdoor or indoor, no signal between ISRSHI and ISRLO is produced, so that the iris control is made impossible. However, by checking the number of pixels HIPIX / MIDPIX / LOPIX of each luminance level, the change of the lighting condition may be determined. For example, if the value HIPIX is far much larger than the value of MIDPIX or LOPIX, the iris diaphragm is opened too much.

At a skin tone mode, the iris diaphragm 12 of the image pickup unit 10 is controlled to derive an average picture level PSKN of the skin tone area from an integral value SSACM of the digital luminance signal Y that specifies the skin tone area inside of the imaged screen, which value is produced by the fourth integrator 63D, and the number of pixels SKPIX that specifies the skin tone area as its specific area, which number is obtained as a count value of the fourth counter 64D, by the following expression of:$\text{PSKN = SSACM/SKPIX}$ and to adjust the average picture level PSKN to a predetermined level. At this skin tone mode, as shown in Fig.5, the color gate signal is multiplied by the input signal and then is output as a sensing signal.

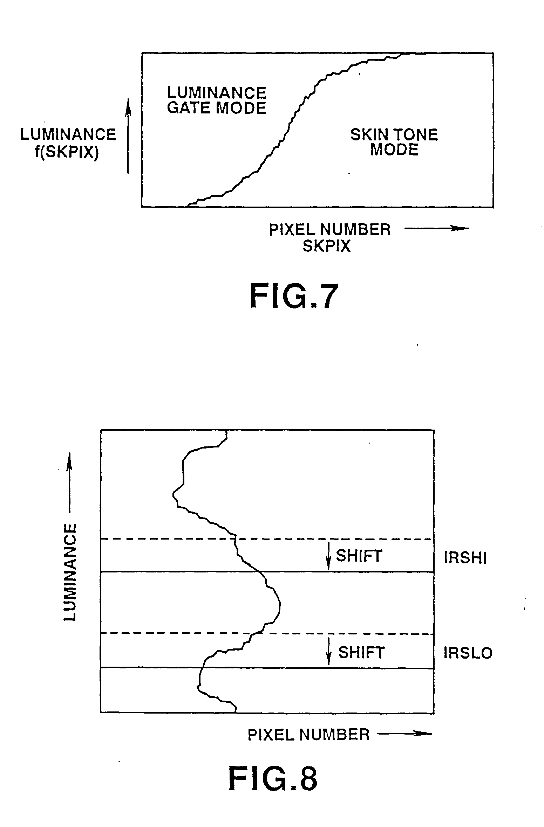

At an intelligent mode, which is a combination of the luminance gate mode and the skin tone mode, the iris diaphragm 12 of the image pickup unit 10 is controlled to derive a middle value between the average picture level PMID of the specific level area at the luminance gate mode and the average picture level PSKN at the skin tone mode as the average picture level PINT and adjust the middle picture level PINT into a predetermined level, At this intelligent mode, the operation is executed to change a mixing ratio of the luminance gate mode to the skin tone mode according to the pixel number SKPIX of the skin tone area, as shown in Fig.7, gradually shift the mode from the luminance gate mode to the skin tone mode as increasing the area of the skin tone area. That is, the average picture level PINT at this intelligent mode is derived by the expression of:$\text{WSKN = f(SKPIX)}$$\text{WMID + WSKN + 1}$$\text{PINT = WMIDPMID + WSKNPSKN}$ where WMID and WSKN are weights for the luminance gate mode and the skin tone mode and the function f(SKPIX) is for deriving a weight WSKN for the skin tone mode from the skin tone area.

At this intelligent mode, the system controller 70 is operated to control the first and the second reference level generators 66 and 67 in a manner to shift both or one of the upper limit IRSHI and the lower limit IRSLO of the luminance at the luminance gate mode in response to the operating input of an up-down switch located on the operation panel 80. At the intelligent mode, this control makes it possible to fine tune the characteristic of the automatic iris-control. That is, for example, as shown in Fig.8, if the range of the Iuminance to be detected is shifted downward, it is determined that the screen is made gloomier, so that the automatic iris-control is executed to open the iris 12. The characteristic of the automatic iris-control is shifted to a bit brighter.

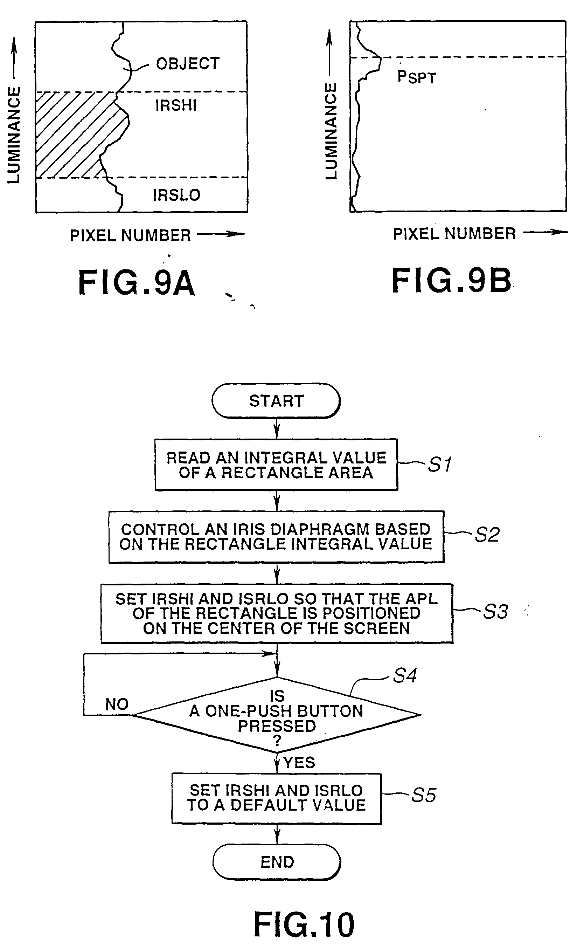

Further, at this intelligent mode, in response to an operating input of the one-push button located on the operation panel 80, the system controller 70 is operated to reset the upper limit IRSHI and the lower limit IRSLO of the luminance at the luminance gate mode according to the procedure shown in Fig.10.

That is, in response to an operating input of the one-push button located on the operation panel 80, the system controller 70 is operated to set the spot mode to one field period immediately after the receipt of the input and derive the average picture level PSPT of the rectangle area SPOT located on the center of the imaged screen (step S1) and to control the iris diaphragm 12 of the image pickup unit 10 to adjust the average picture level PSPT into a predetermined level (step S2). For example, one example of the state of the luminance distribution of the imaged screen before and after the operation of the one-push button, as shown in Figs.9A and 9B, is rearranged to reset the upper limit IRSHI and the lower limit IRSLO of the luminance at the luminance gate mode as follows so that the average picture level PSPT of the rectangle area SPOT is located on the center of the imaged screen (step S3):$\text{IRSHI = PSPT +}$$\text{IRSLO = PSPT.}$

Hence, when operating the one-push button, the target object is positioned on the rectangle area SPOT located on the center of the imaged screen. This positioning makes it possible to properly do the automatic iris-down for the target object.

The system controller 70 iteratively determines if the operating input of the one-push button is received again (step S4). The receipt of the second operating input results in returning the upper limit IRSHI and the lower limit IRSLO of the luminance at the luminance gate mode to a default value and returning the mode to the normal intelligent mode.

An illustrative color image pickup device as described hereinbefore includes first level sensing means for sensing an imaging output level inside of the specific luminance level area on the imaged screen, second level sensing means for sensing an imaging output level of a skin tone area on the imaged screen, and control means for controlling means for controlling light quantity of the color image pickup unit based on each of the detected outputs. Hence, the color image pickup device enables to produce an imaging output having excellent image quality secured therein by switching the control mode of the exposure according to the imaging condition.

In the illustrative color image pickup device the level sensing means includes luminance converting means for converting the color imaging output signal produced by the color image pickup unit, for example, into a luminance signal and the first level sensing means for sensing a luminance signal level of a specific luminance level area specified by the first area generating means based on the luminance signal and thus enables to detect the imaging output level of the specific luminance level area on the imaged screen.

In the illustrative color image pickup device the level sensing means includes the second level sensing means for sensing the signal level of the skin tone area specified by the second area generating means based on the color imaging output signal from the luminance signal supplied from the luminance converting means and thus enables to detect the imaging output level inside of the skin tone area on the imaged screen.

Further, in the illustrative color image pickup device for example, the control means is operated to control the light quantity control means to adjust the first average signal level produced as the sensing output by the first level sensing means, the second average signal level produced as the sensing output by the second level sensing means or the middle signal level between the first average signal level and the second average signal level to a predetermined level. This control makes it possible to switch the control mode of the exposure according to the imaging condition, for producing the imaging output having excellent image quality secured therein.

Moreover, in the illustrative color image pickup device the control means is operated to adjust the interior divisional point between the first average signal level and the second average signal level into the middle signal level and an area ratio of the specific luminance level area to the skin tone area into the interior divisional ratio. This adjustment makes it possible to automatically switch the control mode of the exposure according to the condition of the target object, for producing the imaging output having excellent image quality secured therein.

## Claims

1. An image pickup apparatus comprising:
image pickup means (10) for sensing a picture and generating a corresponding image signal (R, G, B);
automatic iris means (60) for controlling an iris (12) of said image pickup means;
first average picture level detection means (62B, 63B) for detecting a first average picture level (PSPT) of the image signal (Y) within a first area defined by a position (SPOT) in said sensed picture; and
second average picture level detection means (63C) for detecting a second average picture level (PMID) of the image signal within a second area in which a picture level is between a first threshold level (IRSHI) and a second threshold level (ISLO);
characterised by
iris control means (65) for controlling said automatic iris means (60) on the basis of said first or second average picture level; and
means (70) for adjusting the first (IRSHI) and second (IRSLO) threshold levels so that the first average picture level, obtained when the iris control means controls said automatic iris means on the basis of only said first average picture level, becomes a centre level of the adjusted first and second threshold levels.

2. An apparatus as claimed in claim 1, wherein the said first area is positioned in the centre of the picture.

## Patentansprüche

1. Bildaufnahmegerät, mit:
einer Bildaufnahmeeinrichtung (10) zur Abtastung eines Bildes und Erzeugung eines korrespondierenden Bildsignals (R, G, B),
einer automatischen Blendeneinrichtung (60) zur Steuerung einer Blende (12) der Bildaufnahmeeinrichtung,
einer ersten Bildpegelmittelwert-Detektoreinrichtung (62B, 63B) zum Detektieren eines ersten Bildpegelmittelwerts (PSPT) des Bildsignals (Y) in einem durch eine Position (SPOT) im abgetasteten Bild definierten ersten Bereich, und
einer zweiten Bildpegelmittelwert-Detektoreinrichtung (63C) zum Detektieren eines zweiten Bildpegelmittelwerts (PMID) des Bildsignals in einem zweiten Bereich, in welchem ein Bildpegel zwischen einem ersten Schwellenpegel (IRSHI) und einem zweiten Schwellenpegel (ISLO) liegt,
gekennzeichnet durch
eine Blendensteuerungseinrichtung (65) zur Steuerung der automatischen Blendeneinrichtung (60) auf der Basis des ersten und/oder zweiten Bildpegelmittelwerts, und
eine Einrichtung (70) zur Einstellung des ersten (IRSHI) und zweiten Schwellenpegels (IRSLO) derart, dass der erste Bildpegelmittelwert, der erhalten wird, wenn die Blendensteuerungseinrichtung die automatische Blendeneinrichtung auf der Basis nur des ersten Bildpegelmittelwerts steuert, ein Mittenpegel des ersten und zweiten eingestellten Schwellenpegels wird.

2. Gerät nach Anspruch 1, wobei der erste Bereich im Zentrum des Bildes positioniert ist.

## Revendications

1. Appareil de prise de vues comprenant:
des moyens de prise de vues (10) pour détecter une image et produire un signal d'image correspondant (R, G, B),
des moyens d'iris automatique (60) pour commander un iris (12) desdits moyens de prise de vues;
des premiers moyens (62B, 63B) de détection du niveau d'image moyen pour détecter un premier niveau d'image moyen (PSPT) du signal d'image (Y) à l'intérieur d'une première zone définie par une position (SPOT) dans ladite image détectée; et
des seconds moyens (63C) de détection de niveau d'image moyen pour détecter un second niveau d'image moyen (PMID) du signal d'image dans une seconde zone, dans laquelle un niveau d'image est compris entre un premier niveau de seuil (IRSHI) et un second niveau de seuil (IRSLO),
caractérisé par
des moyens de commande d'iris (65) pour commander lesdits moyens d'iris automatique (60) sur la base dudit premier ou second niveau d'image moyen; et
des moyens (70) pour ajuster le premier niveau de seuil (IRSHI) et le second niveau de seuil (IRSLO) de telle sorte que le premier niveau d'image moyen, obtenu lorsque les moyens de commande d'iris commandent lesdits moyens d'iris automatique sur la base uniquement dudit premier niveau d'image moyen, devient un niveau central des premier et second niveaux de seuil.

2. Dispositif selon la revendication 1, dans lequel ladite première zone est positionnée au centre de l'image.
